# EUROPEAN PATENT APPLICATION

(11) **EP 1 434 089 A1**
(43) Date of publication of application: **30.06.2004**
(21) Application number: 02447249.0
(22) Date of filing: 09.12.2002
(51) Int. Cl.: G03F 7/00

(54) **Photo-polymerisable paste compositions**

(71) Applicant: CRIF, 4102 Seraing (BE)
(72) Inventor: Clarinval, Anne-Marie, 1410 Waterloo (BE); Carrus, Raoul, 4470 Saint-Georges (BE); Dormal, Thierry, 4530 Villers-le-Bouillet (BE)
(74) Representative: Van Malderen, Michel

(57) **Abstract**

The present invention is related to a photopolymerisable paste compositions for the photo-fabrication in a stereolithographic process of flexible (A) or hard (B) three-dimensional objects comprising at least a photopolymerisable resin, a main filler and optionally a secondary filler wherein said resin is able to build hydrogen bounds with said main fillers before and/or after the curing process.

## Description

### Field of the invention

The present invention proposes new materials intended for stereolithographic prototyping and in particular energy-ray curable highly-filled polymer compositions.

### State of the art

The traditional way of prototyping consists in achieving a suitable solid three-dimensional object by physical processes such as machining, milling, etc. or even by indentation, moulding and/or casting.

The modern approach relates to a photo-fabrication process, wherein materials are added by the way of superposed layers being successively built in order to obtain a three-dimensional object.

Other processes are based on sintering of metallic and/or plastic powders by thermal treatments. This thermal treatment consists in subjecting the powder layer to a superficial melting step according to the suitable design to obtain the requested three-dimensional object.

Another state-of-the-art method consists in depositing a strip of molten material and wait until the hardening.

The most standard methods relate to stereolithography, which consists in photo-curing a layer of a liquid resin by means of a laser beam in order to obtain the suitable prototype photo-fabrication. An alternative way consists in curing the resin with an UV lamp through a mask. In this way, a three-dimensional object is built, layer by layer, until the target model is achieved.

A mica-filled resin is disclosed by Zeneca in the patent US-6,001,298. This product presents the disadvantage of filler sedimentation under certain conditions and a low Young modulus of the finished prototype.

Optoform® has developed a technology to process paste compositions comprising liquid resins and fillers. The realisation of prototypes in such material requires a high tech equipment, as described in document EP-1 156 921 (WO 00/51809)

The prior art also suggests medium and high viscosity photo-polymerisable resins by UV lasers. Such resins are extensively described in the DSM application WO 00/59972.

### Aims of the present invention

The aim of the present invention is to provide photo-polymerisable pastes for fast prototyping of flexible and hard three-dimensional objects with improved properties. High tear resistance, tensile strength, and elongation characteristics are intended for flexible prototypes as well as high thermal stability, conductivity and compression characteristics for high E-modulus prototypes.

### Summary of the invention

The present invention discloses photo-polymerisable paste compositions for the photo-fabrication in a stereolithographic process of flexible (A) or hard (B) three-dimensional objects comprising at least a photo-polymerisable resin, a main filler and optionally a secondary filler, wherein said resin is able to build hydrogen bounds with said main fillers before and/or after the curing process.

In a first embodiment of the present invention, a photo-polymerisable paste composition of a flexible three-dimensional object (A) is disclosed, wherein said cured object has a glass transition temperature higher than 10°C.

According to the invention, the functional group of said resin comprises carbonyl, imide, urethane and/or thio groups.

The invention discloses that the main fillers are inorganic hydroxides or surface-modified glass beads with OH functions and the secondary fillers are selected from the group consisting of boron nitride, cellulose fibers and glass micro fibers.

A key factor of the present invention is that the composition A is able to produce three-dimensional objects after an irradiation by an active energy ray having an elongation at break of minimum 30% and a tear strength higher than 15 N/mm.

An additional key factor of the present invention is that the photo-polymerisable paste composition A is able to produce three-dimensional objects after an irradiation by an active energy ray having an instant hardness between 35 and 85 (shore A).

In a second embodiment of the present invention, a photo-polymerisable paste composition B able to produce three-dimensional objects after an irradiation by an active energy ray is disclosed, having a tensile strength at break higher than 30MPa, a Young's modulus of more than 4500 MPa, a strength in compression higher than 65 MPa and a strength in flexion higher than 140 MPa.

Furthermore, a process for the photo-fabrication of a flexible (A) or hard (B) three-dimensional objects is disclosed wherein the resin is mixed with the main filler in a first step and optionally the secondary filler in a second step before the resin is cured by an energy ray at an exposure of minimum 0.1 J/cm².

Finally the invention proposes the use of a photo-polymerisable paste composition for fast prototyping in a stereolithographic process.

### Short description of the drawings

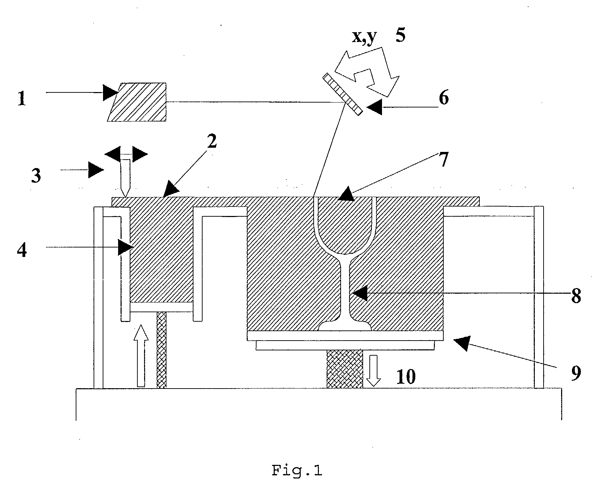

Fig. 1 represents the Optoform® principle of stereo-lithographic fast-prototyping.

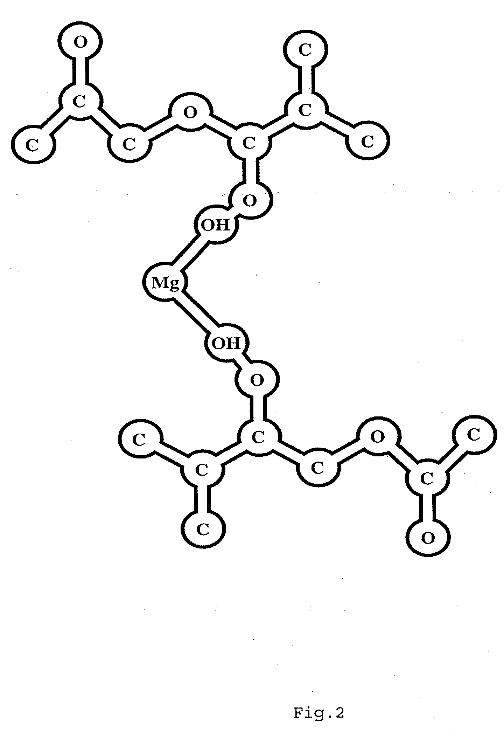

Fig. 2 represents the hydrogen bond interaction between magnesium hydroxide and the 2-hydroxypropyl methacrylate.

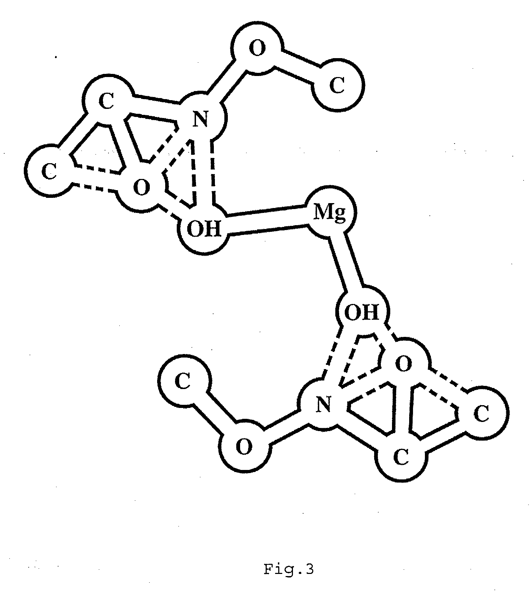

Fig. 3 represents the hydrogen bond interaction between magnesium hydroxide and an urethane function.

### Detailed description of the invention

In the prior art, two processes to manufacture flexible prototypes are known. The first one is a direct method using stereolithographic process machinery, the second one is an indirect process.

The fabrication of a gasket in the indirect manufacturing process involves the following steps. First, a rigid model of the gasket is made by milling or rapid prototyping. Then, a print of the model is taken in a silicon resin to create a mould. In this silicon mould, a urethane resin is cast. Finally, after curing of the urethane resin, the gasket prototype is obtained. This indirect process requires many manufacturing steps, a lot of labour hours and time and can only be considered when a lot of items of the same gasket are required.

Nowadays, photo-fabricated flexible prototypes are known. Physical properties of such flexible gaskets are given in Table 1.

**Table 1**

| Properties | SL-5240 (Vantico) | SL-5520 (Vantico) | Accura SI20 (3D systems) | Somos 201 DuPont |
|---|---|---|---|---|
| Elongation at break (%) ASTM D638 | 22-26 | 23-43 | 18-23 | >100 |
| Hardness (Shore scale) ASTM D2240 | 84 (D) | 80 (D) | 84 (D) | 74-75 (A) |
| Stress at 5% strain ASTM D638 | | | | 1.8-2.2 |
| Stress at 10% strain ASTM D638 | | | | 2.0-2.6 |
| Tensile Strenght ASTM D638 | 36-38 | 26-33 | 28-30 | |
| Tensile Modulus (MPa) ASTM D638 | 227-245 | 1034-1379 | 1176-1245 | 15.5 |
| Initial Tear Resistance 23°C (kN/m) ASTM D624 | | | | 6-23.1 |

The products SL-5240, SL-5520, and Accura SI 20 (3D Systems) present a low elongation at break and are not really adapted to direct gasket prototyping because of a too high tensile strength and hardness values.

The product Somos 201 of DuPont is a powder adapted for a laser sintering process. This material is adapted for the realisation of flexible prototypes but needs an impregnation of a liquid resin to increase its tear resistance and to remove the porosity of the surface. It is furthermore not adapted to the photo-polymerisation process.

The present invention on the opposite relates to paste compositions, comprising medium and high viscosity resins, photo-initiators, fillers and usual additives, such as lubricating agents, anti-oxidants, wetting agents or thixotropic agents.

According to a first embodiment of the present invention, compositions for flexible three-dimensional objects presenting elastomeric characteristics are proposed.

According to another embodiment of the present invention, compositions for rigid three-dimensional objects, for instance for the realisation of injection moulds are proposed. Injection moulds obviously request both mechanical and thermal resistance characteristics. For example, in order to process PP random Copolymers, the required temperature resistance of the material is up to 150-200°C, which is more or less the lowest temperature for injection moulding processes, and allow the injection of a large number of pieces and preferably more than 100.

In the first embodiment, a **material A** can be used for flexible or elastic three-dimensional objects and in the second embodiment a **material B** has been developed to realize rigid mould or models.

The key particularity of both materials in the present invention is the hydrogen bound interaction between the resin and the filler.

The common aspects to materials A and B are:
a) a radically polymerisable organic compound for example urethane, acrylate or methacrylate or a mixture thereof;
b) a photo-initiator or a mixture of several photo-initiators;
c) a thermic catalyst which contributes to generate free radicals for a post-treatment;
d) a main filler which can interact with the resin systems by hydrogen bound, for example Mg(OH)₂, Al(OH)₃, glass beads modified on the surface by OH functions;
e) a secondary filler in order to increase some specific mechanical or thermal properties or in order to adapt the viscosity/rheology properties of the paste. (By changing the nature or the proportion of the secondary filler, it is possible to change the hardness value in the range from 60 to 80 for the instant value and from 47 to 70 for the shore A value measured after 15s).
f) dispersing agent, for example BYK, Avecia, Hypermer products;
g) slipping agent, for example silicon acrylate;
h) anti-oxidant agents, for example Ciba products;
i) thixotropic agent in order to modify the rheology of the paste, for example BYK 410, BYK 411, Avecia products.

### Example of a composition of the flexible material A according to the present invention

**Resins:**
   - Urethan (e.g; PUGSA-Gentec, CN966H90-Cray Valley);
   - reactive solvent (IBOA, HPMA).
**Fillers:**
   - spherical (colloidal or non colloidal silica; magnesium hydroxide; aluminium hydroxide);
   - platelet (nano-clay);
   - micro-fibres (natural cellulose, glass, glass modified in surface);
   - thermal conductor (Boron nitride, barium sulphate, aluminium nitride).
**Photo-initiators:**
   - radical (Ciba: Irgacure 369, Irgacure 651, Irgacure 1850, Darocure 4265, Darocure 1173) (+ co-enhancer);
   - mix of photoinitiators to avoid the inhibition by O₂ and to improve the quantic yield.and the polymerisation depth (BAPO, e.g.: Irgacure 819 ).
**Additives:**
   - dispersing agents (BYK, Avecia);
   - liquid thixotrop agent (BYK).

Examples A1 to A6 of the present invention are shown in table 2.

**Table 2**

| | Resin | Photo-initiator composition (wt%/resin) | Main Filler (%Vol / total) | Second. Filler (%Vol / total) | Rheologic Agent (wt% / resin) | Additive (wt% / resin) |
|---|---|---|---|---|---|---|
| A1 | PUGSA | Irgacure | No | No | Byk410: | Ebecryl |
| | | 1850 | | | 4% | 7100 5% |
| | | 0.5%(/resin) | | | | |
| | | Darocure | | | | |
| | | 1173 0.5% | | | | |
| | | Irgacure.369 | | | | |
| | | 1% | | | | |
| A2 | PUGSA | Irgacure | 34.2% | No | BYK410 4% | Ebecryl |
| | | 1850 | (Vol) | | | 7100 5% |
| | | 0.5%(/resin) | Mg(OH)2 | | | |
| | | Darocure | | | | |
| | | 1173 0.5% | | | | |
| | | Irgacure.369 | | | | |
| A3 | | 1% | | | | |
| | | | 29.4% | No | | |
| | | | Mg(OH)2 | | | |
| A4 | PUGSA | Irgacure | 32.7% | 11.2% | No | No |
| | | 1850 | Mg(OH)2 | Cellules e Fiber | | |
| | | 0.5%(/resin) | | | | |
| | | Darocure | | 402KS | | |
| | | 1173 0.5% | | | | |
| | | Irgacure.369 | | | | |
| | | 1% | | | | |
| A5 | PUGSA | Irgacure | 28.55% | 3.62 % | No | No |
| | | 1850 | Mg(OH)2 | Famix | | |
| | | 0.5%(/resin) | | 1003-A | | |
| | | Darocure | | | | |
| | | 1173 0.5% | | | | |
| | | Irgacure.369 | | | | |
| | | 1% | | | | |
| A6 | PUGSA | Darocure | 26.7% | 10.5% | No | Ebecryl |
| | | 1173 0.7 % | Mg(OH)2 | Cellulos e Fiber 402KS | | 7100 5% |
| | | | | | | |
| | | | | | | |
| A7 | CN966 | Darocure | 29.2% | | | 10% HPMA |
| | H90 | 1173 0.7% | Mg(OH)2 | | | 5.7% Eb |
| | | | | | | 7100 |

The mechanical properties of the polymerised material A1 to A7 are shown in Table 3. These results have to be considered in light of the table 1 giving the mechanical properties of the photo-fabricated soft material.

**Table 3**

| Mechanical Properties | A1 | A2 | A3 | A4 | A5 | A6 | A7 |
|---|---|---|---|---|---|---|---|
| Instant Hardness at 21°C (shore A) ISO 868 | - | 73 | | 73-80 | 60 | 80 | 74 |
| Hardness at 21°C after 15s(shore A) ISO 868 | | 61 | | 65-70 | 47 | 70 | 72 |
| Tensile Strength (MPa) ISO 527 | 0.50 | 3.2 | 2.3 | 3.6 | 2.9 5 | 2.7-3.5 | 5.14 |
| Elongation at break (%) ISO 527 | 69.14 | 39.4 | 55.6 | 35.0 | 100 | 35. | 35 |
| Young Modulus (MPa) ISO 527 | 12 | 11 | 7 | 20 | 10 | 18-19.5 | 18-19.5 |
| Strength at yield (MPa) ISO 527 | No | No | No | No | 3.0 3 | - | - |
| Elongation at yield (%) ISO 527 | No | No | No | No | 80 | - | - |
| Tear Strength (N/mm) ISO 34 | - | 15.3 | | 20.63 | | 15-18 | 25.7 7 |

The mechanical properties present a large range of hardness by changing slightly the composition. The tear strength of material A is generally higher than the tear strength of the soft material in the prior art. The composition of the material A is well adapted to the rapid prototyping by resin curing.

The comparison between A1 and A2 of the tensile properties shows an increase of more than six times of the stress at the break when magnesium hydroxide, is added. The addition of cellulose fiber allows to increase the tear resistance of 35% (comparison of material A2 and A4.) The glass transition temperature has been measured by DSC and is higher than 10°C.

### Composition of the hard material B

**Resins:**
   - acrylate or methacrylate or urethane polyfunctional resins (e.g.:Ebecryl 1259 (UCB), Acrylated glycol-urethane-bisphenol, Ebecryl 8804 (UCB));
   - reactive solvent (IBOA, HPMA,...);
   - silicon acrylate (e.g.: Ebecryl 350);
   - aminoacrylate (e.g.: Ebecryl 7100).
**Fillers:**
   - spherical ([colloidal or non colloidal] silica), magnesium hydroxide, aluminium hydroxide);
   - platelet (nano-clay);
   - micro-fibres (glass);
   - thermal conductor (barium sulphate, boron nitride).
**Photo-initiators:**
   - radical (Ciba: Irgacure 369, Irgacure 651, Irgacure 1850, Darocure 4265, Darocure 1173) (+ co-enhancer);
   - "cocktail" of photoinitiators: avoids the inhibition of O₂, improves the quantic yield and the polymerisation depth (BAPO, e.g.: Irgacure 819).
**Additives:**
   - dispersing agents (BYK, Avecia);
   - liquid thixotrope agent (BYK).

**Table 4**

| N° | Resin | Photo-initiator composition (wt% / resin) | Thermal catalyst (wt% / resin) | Main Filler (%Vol / total) | Secondary Filler (%Vol / total) | Rheol. Agent (wt% / resin) | Additives (wt% / resin) |
|---|---|---|---|---|---|---|---|
| B1 | Ebecryl 1259 | 0.5% Irgacure 1850 0.5% Darocure 1173 1% Irgacure 369 | | No | No | 3% Byk 410 | -5% Ebecryl 7100 -1% Ebecryl 350 |
| B2 | Ebecryl 1259 | 0.5% Irgacure 1850 0.5% Darocure 1173 1% Irgacure 369 | 0.5% Trigonox K-80 | 33.7% Mg(OH)₂ | No | 2% Byk 410 | -5% Ebecryl 7100 -1% Ebecryl 350 |
| B3 | Ebecryl 1259 | 0.5% Irgacure 1850 0.5% Darocure 1173 1% Irgacure 369 | 0.5% Trigonox K-80 | 33% Mg(OH)₂ | 1% (wt) max Aerosil | No | -5% Ebecryl 7100 -1% Ebecryl 350 |
| B4 | Ebecryl 1259 | 0.5% Irgacure 1850 0.5% Darocure 1173 1% Irgacure 369 | 0.5% Trigonox K-80 | 33.7% Mg(OH)₂ | 1.8% Famix 2003-B1 | No | -5% Ebecryl 7100 -1% Ebecryl 350 |
| B5 | Ebecryl 1259 | 0.5% Irgacure 1850 0.5% Darocure 1173 1% Irgacure 369 | 0.5% Trigonox K-80 | 31.9 % Mg(OH)₂ | 6.8% BN | No | -5% Ebecryl 7100 -1% Ebecryl 350 |
| B6 | Ebecryl 8804 | 0.5% Irgacure 1850 0.5% Darocure 1173 1% Irgacure 369 | 0.5% Trigonox K-80 | 40.1 % Mg(OH)₂ | No | No | 30% HPMA |

Properties and application of Material B

**Table 5**

| Properties | B1 | B2 | B3 | B4 | B5 | B6 |
|---|---|---|---|---|---|---|
| Glass transition temperature (°C) DMA | | 84.6 | 76.8 | 79.6 | 82.5 | |
| Thermal conductivity (W/°K m) DIN 52612 | | 0.58 | 0.57 | | | |
| Tensile Strength at break (MPa) ISO 527 | 15.52 | 32.93 | 36.15 | 34.6 | 37.9 | 35.18 |
| Elongation at break (%) ISO 527 | 5.13 | 1.2% | 1.1 | 1.2 | 0.8 | 1.28 |
| Young Modulus (MPa) ISO 527 | 1545 | 4878 | 7049 | 6150 | 7584 | 8075 |
| Flexural modulus (MPa) ISO 178 | | 6270 | | | | |
| Strength in flexion (MPa) ISO 178 | | 158.8 | | | | |
| Y (mm) ISO 178 | | 3.15 | | | | |
| Strength in compression (MPa) ISO 604 | | 93.31 | 67.88 | | | |
| Shore D ISO 868 | | 84-86 | | | | |

| Properties and applications of Material B: | |
|---|---|
| Traction: | Wax casting |
| - Modulus (MPa): 4875-8075 | |
| - Stress (MPa): 33-38 | Injection of items in PP |
| -Deformation: 1-2% | (80 bars, 240°C) |
| Hardness (Shore D): | |
| - modulable 70-85 | injection of items in ABS |
| Vitreous transition: | (400 bars, 240°c) |
| Tg: 80°C | |
| Compression: | |
| 93.31-115 MPa (stress) | |
| Flexion: | |
| - Modulus (MPa): 6270 | |
| - Stress (MPa): 158.8 | |
| - Deformation: 3.15mm | |
| No delaminating | |

The comparison between B1 and B2 tensile strength properties shows an increase of two times of the stress at the break when magnesium hydroxide is added.

The following table allows the comparison of material B and the above-mentioned material patented by Zeneca. Material B presents for a same tensile strength a much higher young modulus. Moreover, the filler in material B is stabilised and does not split from the resin.

### Legend

1: UV-laser
2. paste supply
3. scraper
4. paste tank
5. XY rotation
6. galvanometrical mirror
7. photosensitive paste
8. polymerised prototype
9. piece support
10. z-axis actuator

| Chemical definition of the commercial denominations used in the present invention. | | |
|---|---|---|
| Name or chemical abbreviation* | Company | Chemical family/Formula |
| BYK 410 | BYK | Modified urea solution in N-methylpyrolidone |
| BYK 411 | BYK | Modified urea solution in N-methylpyrolidone |
| Disperbyk 103 | BYK | Solution of a copolymer with pigment affinic groups in methoxypropylacetate |
| Disperbyk 110 | BYK | Solution of a copolymer with acidic groups in methoxypropylacetate and alkylbenzene |
| Disperbyk 111 | BYK | Solution of a copolymer with acidic groups |
| Disperbyk 180 | BYK | Alkylamonium salt of a block copolymer with acidic groups |
| Hypermer KD1 | Uniqema | |
| Hypermer KD2 | Uniqema | |
| Hypermer LP1 | Uniqema | Polycondensed fatty acid |
| Hypermer LP4 | Uniqema | Amine derivative |
| Hypermer LP6 | Uniqema | Fatty ester |
| Hypermer PS2 | Uniqema | Polyoxyalkylene amine |
| Hypermer PS3 | Uniqema | Polyester/polyamine copolymer |
| Hypermer PS4 | Uniqema | Amine modified oligomer |
| Hypermer OD478 | Uniqema | Amine modified oligomer |
| HPA* | | 2-Hydroxypropyl-acrylate |
| HPMA* | | 2-Hydroxypropyl-metacrylate |
| IBOA* | Cray Valley, UCB | Isobornyl acrylate |
| Ebecryl 7100 | UCB | Amine functional acrylate |
| Ebecryl 1259 | UCB | Aliphatic urethane triacrylate/methacrylate diluted with 35% of HPMA |
| Ebecryl 350 | UCB | Silicon diacrylate |
| PUGSA | Gentec | Urethane acrylate |
| CN966H90 | Cray valley | Adhesives, high molecular weight, aliphatic polyester urethane diacrylate |
| Ebecryl 8804* | UCB | Aliphatique urethane diacrylate |
| Darocure 1173 | Ciba Speciality Chemicals | 2-Hydroxy-2-methyl-1-phenyl-1-propanone |
| Darocure 4265 | Ciba Speciality Chemicals | MAPO (Darocure TPO (50%) / α-Hydroxyketone (50%) |
| Irgacure 819 | Ciba Speciality Chemicals | Phosphine oxide, phenylbis(2,4,6-trimethyl benzoyl |
| Irgacure 369 | Ciba Speciality Chemicals | 2-Benzyl-2-(dimethylamino)-1-[4-morpholinyl)phenyl]-1-butanone |
| Irgacure 651 | Ciba Speciality Chemicals | Alpha,alpha-dimethoxy-alpha-phenylacetophenone |
| Irgacure 1850 | Ciba Speciality Chemicals | Bis(2,6-dimethoxybenzoyl)-2,4,4-trimethylpentylphosphineoxide |

| | | |
|---|---|---|
| * Eb 8804 must be desolved in 30% of HPMA. Hypermer LP1, LP4, LP6, PS2, PS3 can also be used | | |

**Tables of fillers:**

| Commercial name(+company) | Nature | Advised for material type |
|---|---|---|
| **Main fillers** | | |
| Nymag 4 (Nyalco) | Mg(OH)₂ | A and B |
| Magmill TP01 (Nyalco) | Mg(OH)₂ | A and B |
| Lhoist | Mg(OH)₂ | A and B |
| RMSL 230 | Al(OH)₃ | A and B |
| RMDF 80 | Al(OH)₃ | A and B |
| | Al(OH)₃ | A and B |
| | Al(OH)₃ | A and B |

| **Secondary Fillers** | | |
|---|---|---|
| (ShS cerámicas) | Boron Nitride | Mainly for B |
| Type 402-KS (Mikro-Technik) | Cellulose fiber | Mainly for A |
| Famix®1003B, C, D (Hollingsworth&Vose) | Glass micro-fiber | A and B |
| Famix®2003B1 (Hollingsworth&Vose) | Glass micro-fiber | A and B |
| Famix®1007 (Hollingsworth&Vose) | Glass micro-fiber | A and B |
| Famix®2303 (Hollingsworth&Vose) | Glass micro-fiber | A and B |
| | Glass micro-fiber | A and B |

## Claims

1. Photo-polymerisable paste compositions for the photo-fabrication in a stereolithographic process of flexible (A) or hard (B) three-dimensional objects comprising at least a photo-polymerisable resin, a main filler and optionally a secondary filler, wherein said resin is able to build hydrogen bounds with said main fillers before and/or after the curing process.

2. Photo-polymerisable paste composition for the photo-fabrication in a stereolithographic process of a flexible three-dimensional object (A) as in claim 1, wherein said cured object has a glass transition temperature higher than 10°C.

3. Photo-polymerisable paste composition as in claim 1 or 2, wherein the functional group of said resin comprises carbonyl, imide, urethane and/or thio groups.

4. Photo-polymerisable paste composition as in any of the previous claims, wherein said main fillers are inorganic hydroxides or surface-modified glass beads with OH functions and wherein the secondary fillers are selected from the group consisting of boron nitride, cellulose fibers and glass micro fibers.

5. Photo-polymerisable paste composition A as in any of the previous claims, able to produce three-dimensional objects after an irradiation by an active energy ray having an elongation at break of minimum 30% and a tear strength higher than 15 N/mm.

6. Photo-polymerisable paste composition A as in any of the previous claims, able to produce three-dimensional objects after an irradiation by an active energy ray having an instant hardness between 35 and 85 (shore A).

7. Photo-polymerisable paste composition B as in any of the previous claims, able to produce three-dimensional objects after an irradiation by an active energy ray having a tensile strength at break higher than 30MPa, a Young's modulus of more than 4500 MPa, a strength in compression higher than 65 MPa and a strength in flexion higher than 140 MPa.

8. Process for the photo-fabrication of a flexible (A) or hard (B) three-dimensional object, wherein the resin according to any of the previous claims is mixed with the main filler in a first step and optionally the secondary filler in a second step before the resin is cured by an energy ray at an exposure of minimum 0.1 J/cm².

9. Use of the photo-polymerisable paste composition as in any of the previous claims for fast prototyping in a stereolithographic process.
